# EUROPEAN PATENT APPLICATION

(11) **EP 0 535 675 A2**
(43) Date of publication of application: **07.04.1993**
(21) Application number: 92116833.2
(22) Date of filing: 01.10.1992
(51) Int. Cl.: G11C 7/00, G11C 11/409

(54) **Semiconductor memory device**

(30) Priority: 01.10.1991 JP 253286/91
(71) Applicant: NEC CORPORATION, Tokyo (JP)
(72) Inventor: Koike, Hiroki, Minato-ku, Tokyo (JP)
(74) Representative: Glawe, Delfs, Moll & Partner

(57) **Abstract**

A data transfer circuit is provided between a sense amplifier and a bit line pair. The data transfer circuit is turned to non-data transfer state at a time immediately before amplifying a read-out signal from a memory cell in the sense-amplifier, and returned automatically to data transfer state for the rewriting operation of the memory cell by receiving an amplified signal from the sense amplifier.

## Description

### FIELD OF THE INVENTION

This invent ion relates to a semiconductor memory device, and more particularly to, a semiconductor memory device using a latched sensing scheme.

### BACKGROUND OF THE INVENTION

In a semiconductor memory device such as a DRAM (dynamic random access memory) or the like, it is important that a sense amplifier circuit, which amplifies a signal read from a memory cell, operates at high speed in order to improve characteristics of the DRAM. A latched sensing scheme which is one of methods for operating a sense amplifier at high speed is described on pages 903 to 911 in IEEE Journal of Solid State Circuits, Vol. 25 - No. 4, August 1990, , entitled "A 55-ns 16-Mb DRAM with Built-in Self-Test Function Using Microprogram ROM".

A conventional semiconductor memory device of latched sensing type includes a plurality of memory cells arranged in matrix, a plurality of row selection lines connected to the memory cells, plural sets of first and second bit lines connected to the memory cells, sense amplifiers connected to the bit lines for differentially amplifying data read from the memory cells, and data transfer circuits connected between the memory cells and the sense amplifiers.

In the conventional semiconductor memory device, when the bit lines are applied with an intermediate-voltage Vp between a power supply voltage and ground voltage and the data transfer circuit is turned on, the sense amplifiers are electrically connected to the memory cells through the bit lines. Then, data stored in the memory cell is read out on the bit line.

Subsequently, when the data transfer circuit is turned off, the sense amplifier is electrically separated from the bit lines. Then, the data read out on the bit lines are amplified by the sense amplifier. After that, when operation of the DRAM is at a reset period, the data transfer circuit is turned on, so that the data is transferred from the sense amplifier to the memory cell through the bit lines. Thus, the transferred data is rewritten in the memory cell.

According to the conventional semiconductor memory device, high-speed sense amplifying can be realized, because the memory device uses a latched sensing scheme, that is, the bit lines are electrically separated from the sense amplifier when the sense amplifying is carried out.

However, there is a disadvantage in that a reset period of the DRAM becomes long, because data is required to be rewritten in the memory cell at the reset period. As a result, operation speed of the DRAM becomes low.

### SUMMARY OF THE INVENTION

Accordingly, it is an object of the invention to provide a semiconductor memory device which operates at high speed.

According to the invention, a semiconductor memory device, comprises:
a plurality of memory cells arranged in row and column directions by a matrix pattern;
a plurality of row selection lines for selection of said memory cells by a unit of rows;
a plurality of bit line pairs for transfer of data from and to selected memory cells;
a pre-charge circuit for setting a selected bit line pair to be a potential which is intermediate between power supply and ground potentials prior to reading data from a selected memory cell;
a plurality of sense amplifying circuits corresponding to said plurality of said bit line pairs, each of said amplifying circuits having data input and output terminal pair to differentially amplify data at said input and output terminal pair;
a plurality of data transfer circuits each provided in parallel between each of said bit line pairs and said each of said amplifying circuits: and
a control circuit for controlling said data transfer circuits, among which a data transfer circuit is at data transfer state at a time of reading data from said selected memory cell, and is at non-data transfer state at a time immediately before amplifying data read from said selected memory cell in a corresponding one of said amplifying circuits to be returned to said data transfer state by receiving an amplified data from said amplifying circuit.

### BRIEF DESCRIPTION OF THE DRAWINGS

Fig. 1 is a circuit diagram showing a conventional semiconductor memory device;
Fig. 2 is a timing chart showing operation of the conventional semiconductor memory device shown in Fig. 1;
Fig. 3 is a circuit diagram showing a semiconductor memory device of a first preferred embodiment according to the invention;
Fig. 4 is a timing chart showing operation of the first preferred embodiment shown in Fig. 3; and
Fig. 5 is a circuit diagram showing a semiconductor memory device of a second preferred embodiment according to the invention.

### DESCRIPTION OF THE PREFERRED EMBODIMENTS

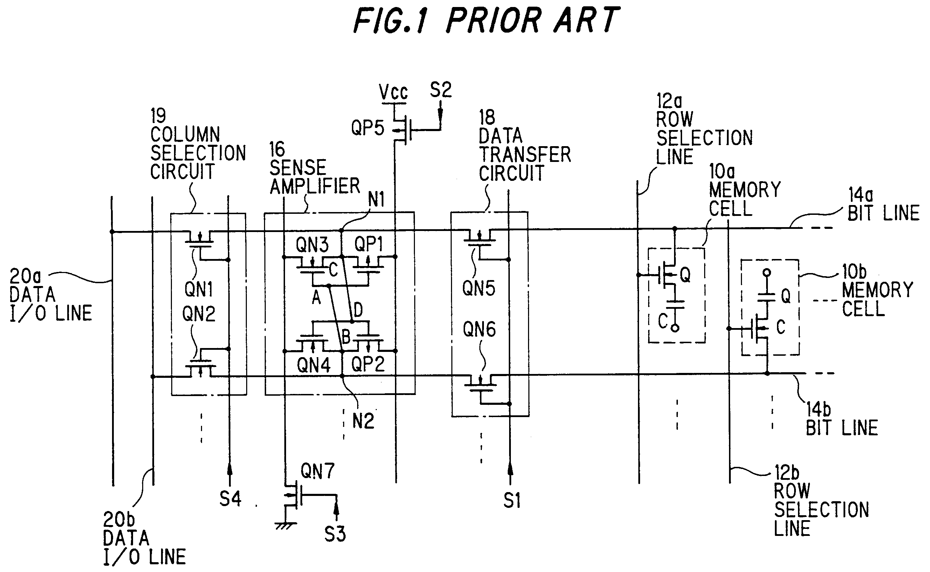

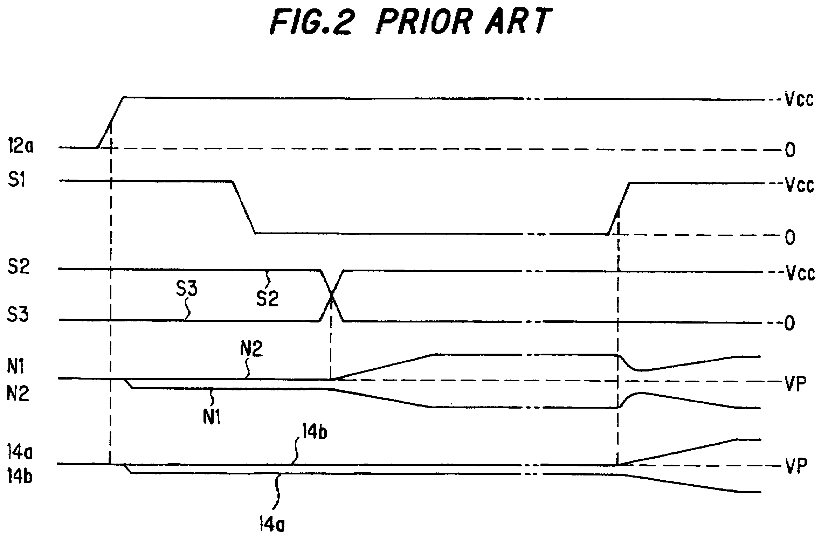

For better understanding the background of the present invention, the basic principle of the conventional technology is first described hereinafter with reference to Figs. 1 and 2.

Fig. 1 shows a conventional semiconductor memory device of latched sensing type. The illustrated portion of the conventional semiconductor memory device includes memory cells 10a and 10b each composed of a transistor Q and a capacitor C and are arranged in matrix, row selection lines 12a and 12b connected to gates of the transistors Q of the memory cells 10a and 10b in each row, first and second bit lines 14a and 14b connected to drains of the transistors Q of the memory cells 10a and 10b, a sense amplifier 16 of flip-flop type for differentially amplifying data read from the memory cells 10a and 10b, a P-transistor QP5 connected at a source to a power supply Vcc and at a drain to the sense amplifier 16, an N-transistor QN7 connected at, a source to ground and at a drain to the sense amplifier 16, a data transfer circuit 18 connected between the memory cells 10a and 10b and the sense amplifier 16, a column selection circuit 19 connected to the sense amplifier 16. The semiconductor memory device further includes a pre-charge circuit (not shown) for applying an intermediate voltage Vp between the power supply voltage Vcc and ground voltage to the bit lines 14a and 14b.

The data transfer circuit 18 is composed of two N-transistors QN5 and QN6 supplied with a control signal S1 at gates.

The sense amplifier 16 includes two data terminals N1 and N2 connected to source-drain paths of the N-transistors QN5 and QN6, an N-transistor QN3 connected at a gate to a node A, at a source to the drain of the N-transistor QN7 and at a drain to a node C connected to the data terminal N1, a P-transistor QP1 connected at a gate to the node A, at a source to the drain of the P-transistor QP5 and at a drain to the node C, an N-transistor QN4 connected at a gate to a node D connected to the node C, at a source to the drain of the N-transistor QN7 and at a drain to a node B connected to the data terminal N2, and a P-transistor QP2 connected at a gate to the node D, at a source to the drain of the P-transistor QP5 and at a drain to the node B.

The column selection circuit 19 is composed of two N-transistors QN1 and QN2 connected to I/O (input/output) lines 20a and 20b by source-drain paths, respectively, for transferring data between the data I/O lines 20a and 20b and the sense amplifier 16 in accordance with a signal S4.

Next, operation of the conventional semiconductor memory device, in a case that data stored in the memory cell 10a is read out to be amplified and rewritten thereinto, will be explained in conjunction with Fig. 2. Before reading out data stored in the memory cell 10a, the bit lines 14a and 14b are set at the intermediate-voltage Vp by the precharge circuit (not shown), and a high signal 12a is applied to the gate of the transistor Q of the memory cell 10a by the row selection line 12a. Then, the control signal S1 of high level is applied to the data transfer circuit 18 so that the N-transistors QN5 and QN6 are turned on. Therefore, the memory cell 10a is selected, and the sense amplifier 16 is electrically connected to the memory cell 10a, so that data stored in the capacitor C of the memory cell 10a can be read out on the bit line 14a.

Subsequently, when the control signal S1 becomes low level to be applied to the data transfer circuit 18, the N-transistors QN5 and QN6 are turned off, so that the data terminals N1 and N2 are electrically separated from the bit lines 14a and 14b, respectively. Then, a signal S2 of low level and a signal S3 of high level are applied to gates of the P-transistor QP5 and the N-transistor QN7, so that the transistor QP5 is turned on and the transistor QN7 is turned off. Thus, the sense amplifier 16 is connected to the power supply Vcc and disconnected from the ground potential, so that the data on the data terminal N1 is amplified.

After that, a level of the control signal S1 is changed low to high to be at a reset period of the memory device, so that the data transfer circuit 18 (N-transistors QN5 and QN6) is turned on, and the data is transferred from the sense amplifier 16 to the memory cell 10a through the bit line 14a. Therefore, the transferred data is rewritten in the memory cell 10a. As a matter of course, the selection of the bit lines 14a and 14b has been made by the selection signal S4 of high level applied to the column selection circuit 19.

According to the conventional semiconductor memory device, a high-speed sense amplifying can be realized, because the memory device uses a latched sensing scheme, that is, the bit lines 14a and 14b are separated from the sense amplifier 16 by the turned-off data transfer circuit 18, when the sense amplifying is carried out. On the other hand, if the, semiconductor memory device does not use a latched sensing scheme, the high-speed sense amplifying can not be realized as shown by chain lines in Fig. 2, because capacitances of the bit lines 14a and 14b lower operation speed of the sense amplifier 16.

However, there is a disadvantage in that a reset period of the memory device becomes long, because rewriting operation is required to be carried out. As a result, a whole operation speed of the memory device becomes low.

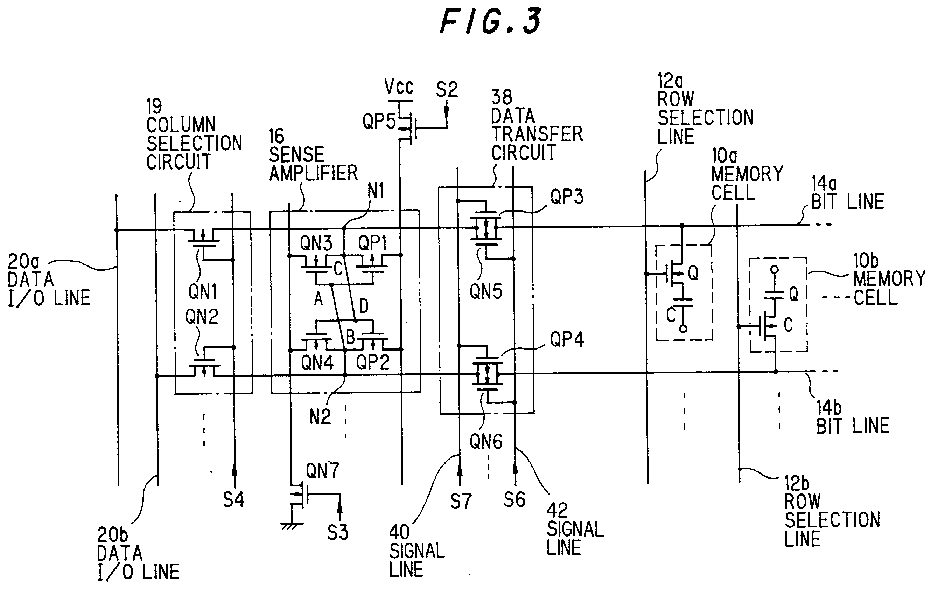

Fig. 3 shows a semiconductor memory device of a first preferred embodiment according to the invention. The illustrated portion of the semiconductor memory device includes memory cells 10a and 10b each composed of a transistor Q and a capacitor C and are arranged in matrix, row selection lines 12a and 12b connected to gates of the transistors Q of the memory cells 10a and 10b in each row, first and second bit lines 14a and 14b connected to drains of the transistors Q of the memory cells 10a and 10b, a sense amplifier 16 of flip-flop type for differentially amplifying data read from the memory cells 10a and 10b, a P-transistor QP5 connected at a source to a power supply Vcc and at a drain to the sense amplifier 16, an N-transistor QN7 connected at a source to ground and at a drain to the sense amplifier 16, a data transfer circuit 38, connected between the memory cells 10a and 10b and the sense amplifier 16, a column selection circuit 19 connected to the sense amplifier 16. The semiconductor memory device further includes a precharge circuit (not shown) for applying an intermediate voltage Vp between the power supply voltage Vcc and ground voltage to the bit lines 14a and 14b.

The sense amplifier 16 includes two data terminals N1 and N2 connected to source-drain paths of the N-transistor QN5 and QN6, an N-transistor QN3 connected at a gate to a node A, at a source to the drain of the N-transistor QN7 and at a drain to a node C connected to the data terminal N1, a P-transistor QP1 connected at a gate to the node A, at a source to the drain of the P-transistor QP5 and at a drain to the node C, an N-transistor QN4 connected at a gate to a node D connected to the node C, at a source to the drain of the N-transistor QN7 and at a drain to a node B connected to the data terminal N2, and a P-transistor QP2 connected at a gate to the node D, at a source to the drain of the P-transistor QP5 and at a drain to the node B.

The column selection circuit 19 is composed of two N-transistors QN1 and QN2 connected to I/O (input/output) lines 20a and 20b by source-drain paths, respectively, for transferring data between the data I/O lines 20a and 20b and the sense amplifier 16 in accordance with a signal S4.

The data transfer circuit 38 includes a P-transistor QP3 connected at a gate to a signal line 40 and at source and drain to the bit line 14a and the data terminal N1 of the sense amplifier 16, an N-transistor QN5 connected at a gate to a signal line 42 and at source and drain to the bit line 14a and the data terminal N1, a P-transistor QP4 connected at a gate to a signal line 40 and at source and drain to the bit line 14b and the data terminal N2 of the sense amplifier 16, and an N-transistor QN6 connected at a gate to a signal line 42 and at source and drain to the bit line 14b and the data terminal N2.

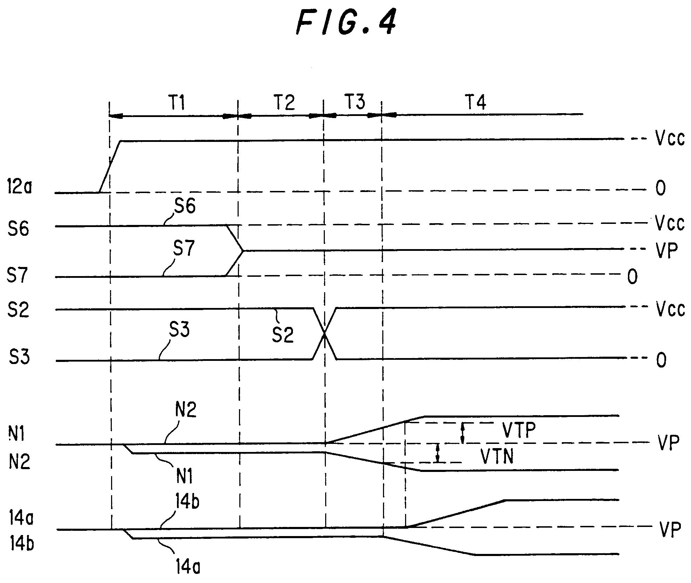

Next, operation of the first preferred embodiment, in a case that a low level data is read from the memory cell 10a, will be explained in conjunction with Fig. 4.

Before reading out data from the memory cell 10a (prior to T), the bit lines 14a and 14b are applied with the intermediate-voltage Vp by the precharge circuit (not shown). In this condition, the transistor Q of the memory cell 10a is turned on in response to a signal of high level supplied through the row selection line 12a, so that data stored in the memory cell 10a is read out on the bit line 14a (T1). The data thus read out is transferred, through the data transfer circuit 38 which is turned on by a signal S6 of high level and a signal S7 of low level to the terminal N1 of the sense amplifier 16. Then, the control signals S6 and S7 becomes at the intermediate voltage Vp to be applied to the data transfer circuit 38 through the signal lines 40 and 42 (T2). At this state, the transistors QP3, QN5, QP4 and QN6 are turned off. Therefore, the sense amplifier 16 is electrically separated from the bit lines 14a and 14b.

Subsequently, a signal S2 is turned to be low and a signal S3 is turned to be high, so that the transistor QP5 is turned on and the transistor QN7 is turned off. Thus, the read data is amplified by the sense amplifier 16 (T3). At this time, loads of the sense amplifier 16 are only the data terminals N1 and N2, so that a high-speed amplifying can be carried out in the same manner as the conventional DRAM shown in Fig. 1.

In this data amplification, when a voltage difference between the data terminal N1 and the control signal S6 is raised over a threshold level VTN of the N-transistor QN5, the transistor QN5 is turned on, so that the amplified data is transferred to the bit line 14a (T4). Thus, the rewriting operation is carried out in the memory cell 10a. In the same manner, when a voltage difference between the data terminal N2 and the control signal S7 is raised over a threshold level VTP of the P-transistor QP4, the transistor QP4 is turned on, so that the amplified data is transferred to the bit line 14b (T4).

As described above, according to the first preferred embodiment, the rewriting operation can be carried out automatically without setting a reset period of the memory device. Therefore, it is possible that the memory device operates at high-speed.

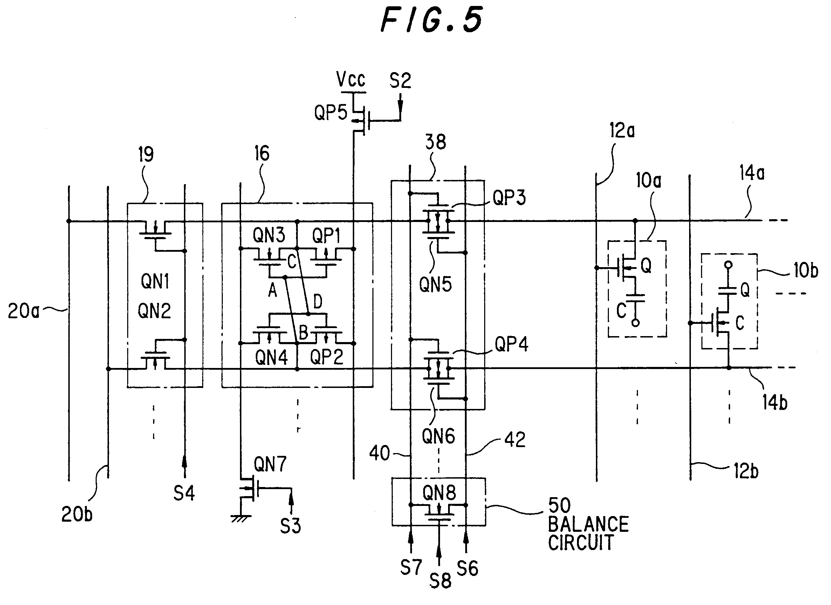

Fig. 5 shows a semiconductor memory device of a second preferred embodiment according to the invention. In this embodiment, explanation for the same structure and the same operation as the first preferred embodiment shown in Fig. 3 will be omitted. The semiconductor memory device includes a balance circuit 50 which is composed of an N-transistor QN8 connected to signal lines 40 and 42 by a source-drain path. Each of gate capacitance of the transistors QP3, QN5, QP4 and QN6 is determined to be equal to parasitic capacitance of the signal lines 40 and 42.

According to the second preferred embodiment, when a control signal S8 of high level is supplied to the N-transistor QN8 of the balance circuit 50, the control signals S6 and S7 become the intermediate voltage level Vp easily.

In this embodiment, a P-transistor or a CMOS transistor may be used instead of the N-transistor QN8.

Although the invention has been described with respect to specific embodiment for complete and clear disclosure, the appended claims are not to be thus limited but are to be construed as embodying all modification and alternative constructions that may occur to one skilled in the art which fairly fall within the basic teaching herein set forth.

## Claims

1. A semiconductor memory device, comprising:
a plurality of memory cells arranged in row and column directions by a matrix pattern;
a plurality of row selection lines for selection of said memory cells by a unit of rows;
a plurality of bit line pairs for transfer of data from and to selected memory cells;
a pre-charge circuit for setting a selected bit line pair to be a potential which is intermediate between power supply and ground potentials prior to reading data from a selected memory cell;
a plurality of sense amplifying circuits corresponding to said plurality of said bit line pairs, each of said amplifying circuits having data input and output terminal pair to differentially amplify data at said input and output terminal pair;
a plurality of data transfer circuits each provided in parallel between each of said bit line pairs and said each of said amplifying circuits: and
a control circuit for controlling said data transfer circuits, among which a data transfer circuit is at data transfer state at a time of reading data from said selected memory cell, and is at nondata transfer state at a time immediately before amplifying data read from said selected memory cell in a corresponding one of said amplifying circuits to be returned to said data transfer state by receiving an amplified data from said amplifying circuit.

2. A semiconductor memory device, according to claim 2, wherein:
said data transfer circuit comprises P-and N-transistors connected at source and drain paths between said bit line pair and said data input and output terminal pair of said amplifying circuit and at gates to said control circuit, said control circuit applying a control signal of a power supply potential to said gate of said N-transistor and a control signal of a ground potential to said gate of said P-transistor at said time of reading said data from said selected memory cell, and applying control signals of a potential which is intermediate between said power supply and ground potentials to said gates said P-and N-transistors at said time immediately before data amplification in said data amplifying circuit.

3. A semiconductor memory device, according to claim 2, further comprising:
a balance circuit for equalizing said intermediate potential control signals applied to said gates of said P-and N-transistors.

4. A semiconductor memory device, according to claim 3, wherein;
said balance circuit is an N-transistor connected at source and drain path to said gates of said P-and N-transistors of said data transfer circuit.
